# EUROPEAN PATENT SPECIFICATION

(11) **EP 0 500 651 B1**
(45) Date of publication and mention of the grant of the patent: **07.05.1997**
(21) Application number: 90916588.8
(22) Date of filing: 13.09.1990
(51) Int. Cl.: B22F 7/00, C06B 45/14, B22F 9/16, C23C 26/00, C23C 10/50, C23C 10/60, C06C 15/00, C06B 45/00

(54) **TREATMENT OF METALS FOR COATING OR ACTIVATION**
METALLBEHANDLUNG IM HINBLICK AUF EINE NACHFOLGENDE BESCHICHTUNG UND AKTIVIERUNG
TRAITEMENT DES METAUX EN VUE DE LEUR REVETEMENT OU DE LEUR ACTIVATION

(30) Priority: 08.11.1989 US 433119; 21.11.1989 US 440026; 30.01.1990 US 472663
(43) Date of publication of application: 02.09.1992
(73) Proprietor: ALLOY SURFACES COMPANY, INC., Wilmington Delaware 19809 (US)
(72) Inventor: BALDI, Alfonso, L., Sea Isle City, NJ 08243 (US)
(74) Representative: Powell, Stephen David
(86) International application number: US9005204
(87) International publication number: WO9107242

(56) References cited:
- WO-A-89/10340
- US-A- 1 969 396
- US-A- 3 142 560
- US-A- 3 250 104
- US-A- 4 349 612
- US-A- 4 435 481
- US-A- 4 694 036
- US-A- 4 756 778
- US-A- 4 824 482
- US-A- 4 830 822
- US-A- 4 871 708
- US-A- 4 895 609
- US-A- 4 927 798
- US-A- 4 957 421
- US-A- 4 965 095
- US-A- 4 970 114
- US-A- 4 977 036

## Description

The present invention relates to the preparation of aluminide particles and more particularly to the preparation of pyrophoric particles on a supporting web, foil or strip.

A preferred embodiment of the present invention will now be described with reference to the accompanying drawings in which:

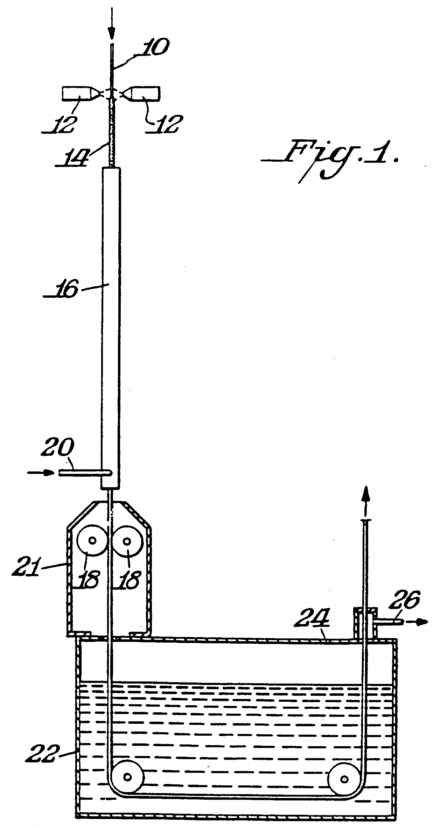

Fig. 1 is a somewhat diagrammatic illustration of an activating treatment in a process according to the present invention. The activating treatment is described in detail in U.S. Patent 4,895,609.

For some purposes it is helpful to have pyrophoric decoy pieces that when discharged into the air from a rapidly moving aircraft, do not immediately slow down and stop their discharge movement. To this end the pieces can be contained in a wire netting that permits them to spread out to only about 10 meters when discharged. Alternatively or additionally, the decoy pieces can be made so that their air resistance is small and inertia high. Thus the carrier web can be tantalum, silver or lead foil as much as 0.019 mm (3/4 mil) thick, and only about 1 square centimetre discs. Silver webs also contribute very good electrical conductivity that provides the pieces with an electrical dipole that helps decoy against radar signals. Copper has a similar dipole effect.

The decoying action can be modified by arranging for a succession of decoy charges to be expelled by a moving aircraft in 20 to 30 second intervals, for example. This appears to a heat-seeking missile as a series of hot clouds that move with the aircraft, and thus becomes a more attractive decoy target.

The pyrophoric behaviour of activated iron particles is different when they are prepared in different ways. The most vigorous behaviour is obtained when the particles and the precursor aluminides from which they are made, are kept from melting during the preparation.

As noted, the pyrophoric material can be prepared as a coating on a thin carrier web as illustrated in Fig. 1.

In Fig. 1, a carrier foil 10 of stainless steel or 1010 steel about 1/40 to about 1/20 millimetre thick is spray coated on both its faces from spray nozzles 12,12 with a binder-containing mixture of iron powder and aluminium powder in a proportion that makes a Raney type alloy. The binder is a resin, preferably an acrylate, dissolved in a solvent-like methyl chloroform. The powder particles are preferably no larger than about 5 to 20 µm.

The thus coated web 14 is led through an externally fired tube 16 of a tube furnace where it is rapidly heated to over 500°C. By that time the coating layers have been dried, the resin binder volatilized off, and the metal powders have interreacted to form the Raney alloy, FeAl₃ for example. After leaving the tube furnace but before the coatings have cooled excessively, the coated web 14 is passed between reduction rolls 18,18 where the hot Raney alloy is compacted to essentially eliminate voids.

A protective gas such as argon is preferably introduced, as at 20, into the furnace tube 16. Some of that gas will rise in tube 16 and thus protect the coated web from the oxidizing action of the ambient air as it heats up. Portions of the gas will also flow down from the exit end of tube 16 and similarly protect the hot emerging web. A cylindrical shell 21 may be positioned about the emerging web to help confine the downwardly-flowing protective gases against the hot web.

The reduction rolls 18,18 should be sufficiently massive so that they are not excessively heated by the hot web. If desired, the rolls can be liquid cooled to help hold down their surface temperature.

The compacted web is then led through a tank 22 containing aqueous caustic soda which dissolves much of the aluminium from the Raney particles on the web. The trip through the caustic soda is preferably arranged to take two to ten minutes, as by adjusting the temperature and concentration of the caustic. The web entering the caustic concentration can be as hot as 600°C and the action of the caustic generates heat, so it is simpler to keep the caustic solution hot, at least about 80°C.

The caustic generates large quantities of hydrogen as it acts on the web, so that a hood 24 can be placed over tank 22, with a suction connection 26 to an aspirator that aspirates off the evolved hydrogen. The web emerging from tank 22 is web with the caustic, and that caustic should be replaced.

The proportions of iron powder to aluminium powder can be varied, nickel powder can be substituted for some or all of the iron powder, and iron or nickel aluminides mixed with the incoming powders. The aluminide formation can also be effected in stages. The presence of a little copper in the sprayed-on coating mixture helps the aluminide coating adhere to a stainless steel web core. Instead of spraying the coating on the web, the web can be dipped in a coating bath, or applied by any other technique. The amount of coating should be such as to leave a compacted web not over about 1/5 millimetre thick.

The carrier may be a strip of 0.0254 mm (1 mil) thick foil about one to two millimetres wide. The hot cloud developed by the decoys is only about 2 meters wide or less, and is effective in its decoy action.

When the coating layers contain iron aluminide, the caustic solution preferably contains a little dissolved tin, as described in the prior art. Also as described in the prior art, a little hydrogen peroxide can also be added to the caustic solution. Potassium hydroxide can be substituted for all or part of the sodium hydroxide.

The aluminide-forming reaction in tube 16 is generally completed in a matter of seconds, so that the web can be passed through the furnace at a rate of about 3 meters per minute, and the furnace tube need be no longer than about 30 or 40 centimetres.

The above-described roll compacting carried out while the web is hot, at least 500°C, is more effective than on a colder web, and only requires a compacting force of about 30 kilograms per centimetre width of the web. Compacting can also be effected on the leached web, that is the web leaving the caustic solution, but is not as effective and is not within the scope of the present invention. The aluminide particles on the leached web are softer than those on the unleached web when the webs are at room temperature, but heating a pyrophoric leached web in an attempt to soften the leached particles adversely affects their pyrophoricity. The greater the compaction, the more pyrophoric strips can be packed into a decoy shell used against heat-seeking missiles.

By way of example, a one-meter-long induction coil furnace can be provided for coated foil to move through at the rate of two meters per hour, followed by a five-centimetre gap through which the foil cools by radiating its heat to the surroundings, and then a ten-centimetre travel through a leaching bath held at 87.8°C (190°F). Following that bath the foil moves through a falling stream of rinse water that terminates the leaching, rinses off the leachant, and cools the foil to about room temperature. The water-web foil can then be dried under argon and spooled.

There is generally no need to use a diffusion coating energizer such as ammonium chloride in the atmosphere adjacent the surface being diffusion coated by the foregoing technique, but it can be used and will then help if the incoming foil has not been completely cleaned. Blasting with a stream of blasting grit generally does an adequate cleaning. With or without an energizer in an inert or reducing diffusion atmosphere, a continuous spray of aluminium on a continuously fed foil, or a continuous passage of such a foil through or on a body of molten aluminium, does not leave objectionable roughness.

However, the smoothness of the sprayed-on aluminium layer does not assure suitable diffusion aluminizing when the diffusion step is conducted at elevated temperatures, i.e. about 704°C (1300°F). Thus a 0.0508 mm (two-mil) thick 1010 type steel when sprayed with molten aluminium and rapidly heated to 787°C (1450°F) where it is kept for 30 minutes and then cooled, becomes wrinkled and distorted. A similar distortion problem is experienced by a 10-minute diffusion heat at 871°C (1600°F). Such wrinkling and/or distortion makes it awkward to manipulate the foils, but essentially entirely disappears during the leaching, and so does not significantly prevent the tight packing of such activated foils in containers for use as thermal decoys. Sprayed-on aluminium coatings weighing from about 5 to about 30 milligrams per square centimetre, whether sprayed on as molten aluminium or as a slurry of aluminium particles, lead to the wrinkling and distortion.

For activating only one face of the foil, the other face can be protected or masked against diffusion, or the aluminium spray coating can be confined to the one face to be diffusion coated. This also leads to distortion and wrinkling.

Pre-alloying the aluminium with 5% to 15% silicon by weight reduces the wrinkling and distortion, but does not eliminate them completely. However, the diffusing in of a pre-coated foil yields after leaching an activated product having a thermal output when exposed to air, somewhat less than that of foils prepared by pack diffusion. Alloying with other materials such as zinc, calcium, germanium, magnesium, nickel and boron, also reduces the wrinkling and distortion but has less of an adverse effect on the thermal output. Conducting the leaching at elevated temperatures such as over 104°C (220°F), and particularly with aqueous solutions of at least 20% caustic soda or potash by weight also helps.

Wrinkling and distortion can also be reduced by conducting the diffusion at lower temperatures. Below about 538°C (1000°F), the wrinkling and distortion is completely prevented, but the diffusion time is increased to as much as four hours or more. Also at these low temperatures ammonium chloride is not a preferred energizer and pack diffusion is simpler to conduct. Such low-temperature pack diffusion is best conducted with extra precautions to avoid side reactions such as etching, that are caused by the presence of moisture. Thus anhydrous water-insoluble CrCl₃ can be used as the energizer or the diffusion-coating pack can have embedded in it one or more packets of anhydrous aluminium chloride in which that energizer is sealed in an envelope made of plastic sheeting that melts and decomposes at about 149°C to 332°C (300°F to 600°F). Polyethylene and polyethylene terephthalate plastics are suitable for this purpose. As the packet-containing diffusion-coating pack is heated to diffusion-coating temperature in a loosely covered retort contained in an outer retort whose interior is kept flushed with argon or the like, any moisture in the inner retort is first driven out and flushed away, after which the packet walls melt and decompose to liberate the anhydrous aluminium chloride so that it can volatilize and effect the necessary energizing. It is desired to minimize the presence of carbonaceous material such as that resulting from the aplastic melting and decomposition, the packets can be made of aluminium foil folded over and cemented together by means of a very thin plastic coating.

Wrinkled and distorted foils can also be subjected to a flattening treatment as by rolling between thickness-reducing rollers. The pressure applied by these rollers should only be enough to effect very little or no thickness reduction.

Pyrophoric stainless steel screens and foils can be prepared on a continuous basis, as described above for the plain steel foils. Thus, very high pyrophoricity is developed with type 430 stainless steel screening woven from 0.508 mm (20 mil) thick wire aluminized with a 0.0508 mm (2 mil)-thick case having a surface aluminium content of 50 weight percent, leached for only about 1/2 minute with a 50% aqueous solution of NaOH held at about 138°C (280°F). Leaching solutions as strong as saturated aqueous caustic can be used at temperatures as high as 149°C (300°F), even shorter leach times being then preferred, but 40% NaOH solutions at 71°C (160°F) are preferably used for as long as 30 minutes to develop high pyrophoricity. It is not helpful to have stannite tin present in leaching solutions that are used to leach stainless steels.

Where the leaching solution is stronger than 50%, as for example when using solutions that are saturated with caustic at the leaching temperatures, the leaching times are further shortened by about 1% for every 0.5°C (degree Fahrenheit) increase in leaching temperature about 143°C (290°F). A leaching solution that has been used loses a little of its activity both because some of its caustic is consumed and because soluble aluminate salts are formed in it. A leaching bath originally having a 50% caustic concentration but used to the point that its caustic concentration has been reduced to 40% by weight, actually has a leaching action more closely corresponding to a fresh 35% caustic concentration.

The diffusion aluminizing conducted to provide pyrophoric stainless steels is very effective when carried out at temperatures of about 427°C (800°F) to about 899°C (1650°F), and is followed by a vigorous leaching with aqueous caustic having at least 25% NaOH by weight. If more than about 15 milligrams of aluminium is leached out per 6.45 cm² (square inch) by vigorous leaching with aqueous caustic having at least 45% caustic, the leached case becomes loosened and can then be removed by rubbing, for instance.

The radar reflectivity associated with pyrophoric foils is increased by mixing them with standard aluminium radar chaff or foils. Such aluminium chaff or foils only about 0.0127 mm (1/2 mil) thick or thinner, mixed with two to five times as many pyrophoric 2.54 cm (one-inch) discs of iron foil, make an effective heat and radar decoy when ejected as a mass from an exploding cartridge.

In processes according to the present invention, there are provided highly active-heat-generating compositions which burn in air when heated, but are essentially inert at temperatures below about 50°C to 100°C so they can be conveniently stored for use when desired.

As shown, pyrophoric materials prepared by leaching FeAl₃ or NiAl₃ for example, can be stabilized by subjecting them to a very small quantity of oxygen in a manner that does not permit them to appreciably heat up, the resulting stability tends to break down at about 50°C or a little higher.

In processes according to the present invention, there are provided pyrotechnic compositions which ignite at temperatures about 100°C, e.g. at about 300°C, and have a substantial aluminium content as well as a high thermal output. These compositions are activated aluminides of metals like molybdenum, zirconium and columbium that when not combined with aluminium ignite in air at about 500°C to 700°C or higher at atmospheric pressure. These metals are easily combined with aluminium to form alloys or aluminides having two or more atoms of aluminium for each atom of ignitible metal, and when so combined generally have ignition temperatures not much different from that of the pure ignitible metal as noted above. Incorporating about 2% to about 10% boron in such alloy, based on the weight of the ignitible metal, generally lowers the ignition temperature by about 20°C or somewhat more. However, the ignition temperature of the aluminide with or without the boron, is lowered about 100°C to about 150°C or more by activating the aluminide.

The activation of the present invention involves the leaching out of some of the aluminium, as with aqueous caustic soda or caustic potash. For this activation, the aluminium alloy preferably has between about 2.5 and 3.5 atoms of aluminium for every atom of alloyed ignitible metal, and the leaching preferably removes all the aluminium in excess of two atoms per atom of ignitible metal.

The activities of the activated alloys are lower when the leaching is terminated earlier, and are also lower when the alloys subjected to the activation have a less than 3:1 proportion of aluminium atoms to ignitible metal atoms. There are also some reactivity increases when the leaching is made more intense, as by starting with a hot or boiling caustic solution, and by increasing the caustic concentration to saturation. However, very good reactivity is obtained when the leaching is effected at 20°C, although the leaching is slower at that temperature. At boiling temperatures with saturated caustic, the leaching can be completed in less than two minutes.

It is not essential for the aluminides of the present invention to be prepared by melting. Thus, iron, zirconium, titanium, molybdenum and columbium can be effectively alloyed with aluminium by a thermal diffusion. Fine powders of the separate alloy ingredients can be uniformly mixed in a diffusion coating retort and heated to about 600°C in an AlCl atmosphere for only about six hours to produce usable alloy when the ignitible metal powder particles are no larger than about 10 µm. Larger particles take a little longer. Other halide atmospheres, such as of anhydrous CrCl₃, either in its water-soluble or water-insoluble form, or elemental chlorine, bromine or iodine, can be used in place of the AlCl₃ as the diffusion-energizing atmosphere. Only about 1/2% to about 1% of such energizer is mixed with the powders to be alloyed.

Tri-aluminides of some of the noted metals are also available as articles of commerce.

The leaching of the present invention can also be effected with inhibited hydrochloric acid but the resulting activation is not as great as produced by caustic leaches.

There can also be included in the foregoing alloys ingredients that improve the pyrotechnic behaviour.

Thus, about 2% to 20% of boron or magnesium or iron or mixtures of these, are helpful in this respect, and can be added to a melt or to a diffusion-alloying mixture. Also, these metals can be introduced by diffusion into a pre-formed aluminide or by diffusion with the aluminium. For example, 250 grams of powdered ZrAl₄ can be mixed with 10 grams of powdered boron and 5 grams of sodium fluoborate, and subjected to a diffusion heat as described in U.S. Patent No. 3,801,357, but without using inert solid diluent, for three hours at 982°C (1800°F) in an argon-bathed atmosphere, to diffuse the zirconium and boron into aluminized nickel powder or NiAl₃.

About 1% to about 10% of iron can be similarly introduced into the aluminide with or without the boron, to provide activatable alloys that after activation ignite at temperatures of about 300°C or a little lower. Magnesium-aluminium alloys can also be activated by the foregoing techniques to provide activated material having ignition temperatures below 300°C. The magnesium-aluminium alloys preferably have, before activation, at least two atoms of aluminium for every atom of magnesium, but can be activated even when the aluminium-magnesium atom proportion is as low as 1½:1. The aluminium-to-zirconium atom ratio is preferably at least 4:1 but can be as low as 2:1.

Including 2% to 20% boron in the magnesium-aluminium or zirconium-aluminium alloys, based on the weight of the magnesium or zirconium, also increases their pyrotechnic output.

The foregoing pyrotechnic improvements are obtained with alloys in the form of foils and sheets.

The boron additions of the present invention can also be effected by the procedures described in U.S. Patent No. 4,536,215.

A stainless steel foil can be provided with a catalytic pyrophoric surface, by first plating the stainless steel surface with nickel or iron, then aluminizing the plated surface, and finally leaching the aluminium out of the plating. Thus, a 0.0254 to 0.0508 mm (one to two mil) thick acid nickel electroplate on 304 stainless steel can be aluminized at 399°C to 427°C (750° to 800°F) for twelve hours, as in U.S. Patent No. 4,154,705, to provide an aluminium pick-up of 1.9 to 2 milligrams per square centimetre, after which the aluminized surface can be leached in hot 20% aqueous NaOH to reduce the pick-up to about 1.9 to 2 milligrams per square centimetre. This leaves a stainless steel foil with a very active surface highly suited for a water-electrolyzing electrode, anode or cathode, with reduced over-voltage. It is also suitable for use as a fuel cell electrode, both anode and cathode.

The active nickel surface becomes warm when first exposed to air, showing that it is pyrophorically reacting with the air. Its best cathodic electrolyzing effects are provided if kept from exposure to air or oxygen. These results are also obtained when the aluminizing is conducted at other temperatures and for other times and with other diffusion-coating packs. Similarly, the nickel platings can be deposited by ion bombardment, gas plating or other techniques, and the stainless steel can be of any other type. The stainless steel foil need not be more than about 10 mils thick.

The high diffusion temperatures suggested in U.S. Patent No. 4,116,804 are not desirable for aluminizing a stainless steel supported thin nickel or iron layer, inasmuch as high diffusion temperatures tend to cause some of the chromium from the stainless steel to diffuse into the thin nickel or iron layer and lower its activity for electrolytic use. It is accordingly desirable to keep the diffusion temperature below 593°C (1100°F) and to limit the dwell time at diffusion temperature to prevent chromium from reaching the outer surface of the nickel or iron coating.

The nickel or iron top coating can be given a top flash plating of silver or platinum about 0.00127 mm (0.05 mil) to about 0.0127 mm (0.5 mil) thick, before the aluminizing. Such a flash coat of nickel over an iron-plated stainless steel is also helpful.

Similar flash coatings can be applied over the activated nickel or iron plated stainless steels after the activation is completed by aluminizing and leaching.

Even without the stainless steel backings, a self-supporting iron or nickel screen or foil having its surfaces activated as noted, with or without the flash top coatings, make very good fuel cell electrodes, much like the similar activated metals of British Specification No. 1,289,751.

The leaching of aluminized iron foils is improved when conducted with a little hydrogen peroxide in the leaching liquid. As little as 0.1% H₂O₂ by weight of the leachant is enough to show such results, and from about 0.2% to about 0.5% is preferred. Concentrations of 3% or higher tend to darken the work and diminish its pyrophoric activity.

By way of example, to a litre of 10 weight percent solution of NaOH in water there is added 5 grams of SnCl₂, 2H₂O and 5 ml of 30% aqueous H₂O₂, and the resulting mixture at room temperature is used to leach 0.0508 mm (2 mil) thick iron foil that has been aluminized to a depth of 0.0127 mm (1/2 mil) on both its faces. The leaching generates a very small amount of gas as compared to corresponding leaching without the H₂O₂, and is completed in about 30 minutes even if the leach solution warms up to about 50°C during the leaching. Essentially no sludge precipitates from the leach solution, even though a large quantity of tin-containing sludge precipitates if the H₂O₂ is omitted.

About the same results are obtained when the leachant is KOH and starting leach solution is at any temperature from about zero to about 50°C, although leachant that starts at 50°C can heat up to about 60°C. The foregoing leachings are conducted with about one hundred times as much leach solution as substrates being leached, by weight. Preferred caustic concentrations are from about 8% to about 20% NaOH of KOH in water, by weight.

Instead of pouring H₂O₂ into a leach solution, peroxides such as sodium peroxide, potassium peroxide and calcium peroxide can be added to the leach solution to form H₂O₂ in situ.

The foil activated in accordance with the foregoing example also shows a small gain in pyrophoric heat output as compared to the corresponding foil activated without the help of the H₂O₂.

Leaching of aluminized iron foil is best conducted with some tin or stannite ion dissolved in the leachant, but the concentration of the tin can be reduced to as little as about 1/2 gram dissolved tin per litre of leachant when H₂O₂ is present in the leachant. Preferably the dissolved tin content is as high as 1 to 3 grams per litre.

Not only is less tin needed in the leachant, but the iron activated with the H₂O₂ in the leachant contains less tin than is contained in iron activated pursuant to the prior art. Such tin is introduced as metal into the pores of the activated iron and even in very small amounts helps preserve the activation.

It is noted that the presence of the H₂O₂ in the leachant has an effect opposite to that of the H₂O₂ when it is applied to the activated metal after the leaching is completed. Such later application causes the activated metal to lose some or all of its pyrophoricity, and to turn black.

The small increase in heat output caused by the presence of the H₂O₂ in the leachant, can be heightened by subsequently subjecting the activated metal to the short treatment with dilute acid, with or without the folding, as described above.

The foregoing leaching, with or without the H₂O₂, is also very effective for leaching the rapidly formed sintered aluminium alloys. Those alloys are of the Raney type formed by placing the alloy precursor metals on a carrier and then rapidly heating the combination to a temperature high enough to trigger the inter-reaction of the precursor metals.

A particularly desirable technique uses as a carrier inexpensive steel such as type 1010, in the form of a foil about 25 to 50 µm thick. Such a foil can be seriously embrittled by the inter-reacting metals at the high inter-reaction temperatures generated, and to avoid excessive damage, the precursor metals are applied in at least two stages, with the first stage arranged to generate relatively low inter-reaction temperatures. Thus the atomic proportion of the aluminium to the iron, nickel or cobalt precursors should be no greater than about 2, or the metal alloying with the aluminium should be mostly iron, or the precursors can be diluted with preformed alloy, or combinations of these techniques used.

### EXAMPLE

A coating binder is prepared by dissolving 10 parts by weight of acrylate resin in 90 parts of acetone. Into 100 grams of this solution is stirred the following powders:
- 220 grams: Al (1-3 µm particle size)
- 207 grams: Fe (0.043 mm (minus 325) mesh)
- 75 grams: Cu (0.043 mm (minus 325) mesh)

The resulting dispersion is applied by dipping onto both faces of a 302 steel foil about 12.5 µm thick, to build up coatings that air dry to a thickness of about 125µm. The coated foil, before or after drying, is subjected to the above-described sintering and leaching treatment and is compacted before the leach. Under argon or under water it is then cut into 2 cm x 2 cm squares that when dry immediately become incandescent upon exposure to air.

The addition of 5 grams amorphous boron to the powders sharply increases the intensity of the pyrophoric action. On the other hand, the addition of 5 grams Al₂O₃ or MgO powder reduces its intensity and delays its incandescence onset. Reducing or eliminating the copper reduces somewhat the adhesion of the sprayed-on coatings, and is undesirable.

Type 302 steel is sufficiently heat-resistant that a 15 µm thick foil can be perforated, for example, with openings 1 millimetre wide spaced 1 millimetre from each other, and still provide the foregoing results.

The pyrophoric material should be kept away from oxygen, as by being thoroughly wet with water or other protective liquid, to preserve it against changes. It can be cut to short lengths for loading into a decoy shell used for protecting aircraft against heat-seeking missiles. It can also be stabilized by contacting it with very low concentrations of oxygen, as described in Patent 4,820,362, to render it non-pyrophoric unless heated to above 50°C.

## Claims

1. A process of preparing pyrophoric aluminide particles on a supporting web, foil or strip by leaching, including the steps of first compacting the precursor aluminide particles on the web at a temperature above about 400°C to essentially fill all the voids followed by leaching to dissolve out most of the aluminium.

2. A process according to claim 1, wherein the precursor aluminide particles form an unmelted Raney type iron-aluminium alloy before the compacting step, and the alloy is then leached to dissolve out most of the aluminium to thus leave an activated iron.

3. A process according to claim 2, wherein the unmelted alloy is in the form of particles not over about 100 µm in size.

4. A process according to claim 2 or 3, wherein the unmelted alloy is provided by the low temperature diffusion aluminizing of iron particles.

5. A process according to any preceding claim, wherein the leaching is effected with aqueous caustic containing dissolved tin.

6. A process of preparing pyrophoric aluminide particles according to any preceding claim followed by the process of discharging a mass comprising the prepared particles as a countermeasure against a heat-seeking missile.

## Patentansprüche

1. Ein Verfahren zur Herstellung pyrophorer Aluminidpartikel auf einem Träger in Form eines Bandes, einer Folie oder von Streifen durch Auslaugen, umfassend die Verfahrensschritte, bei denen die Vorläuferaluminidpartikel auf dem Band zuerst bei einer Temperatur von ungefähr 400°C verdichtet werden, damit alle die Fehlstellen, die durch Auslaugen, um den überwiegenden Anteil an Aluminium herauszulösen, entstanden sind, im wesentlichen wieder aufgefüllt werden.

2. Ein Verfahren nach Anspruch 1, bei dem die Vorläuferaluminidpartikel vor der Verdichtung eine ungeschmolzene Eisen-Aluminiumlegierung des Raney-Typs bilden und die Legierung dann ausgelaugt wird, um den überwiegenden Anteil an Aluminium herauszulösen, um auf diese Weise ein aktiviertes Eisen zurückzulassen.

3. Ein Verfahren nach Anspruch 2, bei dem die ungeschmolzene Legierung in Form von Partikeln vorliegt, deren Größe ungefähr 100 nicht übersteigt.

4. Ein Verfahren nach Anspruch 2 oder 3, bei dem die ungeschmolzene Legierung durch das bei niedriger Temperatur stattfindende Diffusionsaluminisieren von Eisenpartikeln gebildet wird.

5. Verfahren nach einem der vorhergehenden Ansprüche, bei dem das Auslaugen mit einem wässrigen Ätzmittel, in dem gelöstes Zinn enthalten ist, bewirkt wird.

6. Verfahren zur Herstellung von pyrophoren Aluminidpartikeln nach einem der vorangehenden Ansprüche, dem das Verfahren zum Entladen einer Masse folgt, die die hergestellten Partikel enthält, als Gegenmaßnahme gegen ein wärmesuchendes Fernlenkgeschoß.

## Revendications

1. Procédé de préparation de particules d'aluminures pyrophores sur une feuille, une feuille mince ou une bande de support par lixiviation, comprenant les étapes de compactage, tout d'abord, des particules d'aluminures précurseurs sur la feuille à une température supérieure à environ 400°C pour remplir essentiellement tous les vides, cette première étape étant suivie d'une lixiviation pour dissoudre la majeure partie de l'aluminium.

2. Procédé selon la revendication 1, dans lequel les particules d'aluminures précurseurs forment un alliage de fer et d'aluminium non fondu de type Raney avant l'étape de compactage, et l'alliage est ensuite lixivié pour dissoudre la majeure partie de l'aluminium pour laisser ainsi un fer activé.

3. Procédé selon la revendication 2, dans lequel l'alliage non fondu se présente sous la forme de particules qui ont une taille qui n'est pas supérieure à environ 100 µm.

4. Procédé selon la revendication 2 ou dans lequel l'alliage non fondu est formé par l'aluminisation par diffusion à basse température de particules de fer.

5. Procédé selon l'une quelconque des revendications précédentes, dans lequel la lixiviation est effectuée avec une matière caustique aqueuse contenant de l'étain dissous.

6. Procédé de préparation de particules d'aluminures pyrophores selon l'une quelconque des revendications précédentes, suivi par le procédé de décharge d'une masse comprenant les particules préparées comme contre-mesure contre un missile à tête thermochercheuse.
